(19) Europäisches Patentamt
European Patent Office
Office européen des brevets

(11) **EP 0 961 130 B1**

(12) **EUROPÄISCHE PATENTSCHRIFT**

(45) Veröffentlichungstag und Bekanntmachung des Hinweises auf die Patenterteilung:
**25.03.2009 Patentblatt 2009/13**

(51) Int Cl.:
***G01R 31/34*** *(2006.01)*

(21) Anmeldenummer: **99110164.3**

(22) Anmeldetag: **26.05.1999**

(54) **Verfahren und Anordnung zur Früherkennung von Läuferschäden bei Asynchronmaschinen**

Method and apparatus for early detection of faulty rotors in asynchronous machines

Procédé et appareil pour la détection précoce de défauts de rotor dans une machine asynchrone

(84) Benannte Vertragsstaaten:
**AT CH DE ES FR IT LI NL SE**

(30) Priorität: **28.05.1998 DE 19823787**

(43) Veröffentlichungstag der Anmeldung:
**01.12.1999 Patentblatt 1999/48**

(73) Patentinhaber: **Bombardier Transportation GmbH**
**10785 Berlin (DE)**

(72) Erfinder: **Hackmann, Wilhelm**
**2371 Hinterbrühl (AT)**

(74) Vertreter: **Cohausz & Florack**
**Patent- und Rechtsanwälte**
**Postfach 10 18 30**
**40009 Düsseldorf (DE)**

(56) Entgegenhaltungen:
CN-A- 1 099 481      FR-A- 2 683 049
US-A- 4 761 703      US-A- 5 049 815
US-A- 5 739 698

• ELKASABGY N M ET AL: "DETECTION OF BROKEN BARS IN THE CAGE ROTOR ON AN INDUCTION MACHINE" IEEE TRANSACTIONS ON INDUSTRY APPLICATIONS, Bd. 28, Nr. 1, 1. Januar 1992 (1992-01-01), Seiten 165-171, XP000297279 ISSN: 0093-9994

**Beschreibung**

Die Erfindung betrifft ein Verfahren und eine Anordnung zur Früherkennung von Läuferschäden bei Asynchronmaschinen gemäß dem Oberbegriff des Anspruchs 1.

Asynchronmaschinen mit Kurzschlußläufer kommen als drehzahlvariable Antriebe auf elektrischen Schienenfahrzeugen zum Einsatz. Die Läuferkäfige dieser Asynchronmaschinen unterliegen im Wechselrichterbetrieb vielfältigen Beanspruchungen, die im Extremfall zu Läuferschädigungen, d.h. Läuferstabanrissen bzw. - brüchen, führen können. Diese Schäden haben eine Überlastung der benachbarten Stäbe und oft eine Ausweitung der Schäden zur Folge, im Extremfall einen Totalausfall des Motors.

Die frühzeitige Erkennung von Schadläufern ist daher wünschenswert.

Es ist aus der Literatur bekannt, daß ein unterbrochener Läuferstab zu einer Verzerrung des Luftspaltfeldes führt (Deleroi, W.: "Der Stabbruch im Käfigläufer eines Asynchronmotors", Archiv für Elektrotechnik 67, 1984; Krebs, R.: "Läuferanisotropien bei Asynchronmaschinen mit Kurzschlußläufer", Archiv für Elektrotechnik 71, 1988). Die Verzerrung des Luftspaltfeldes kann als eine Überlagerung von ungestörtem Feld und einem räumlich an den Läufer gebundenen Störfeld beschrieben werden. Von besonderem Interesse sind in diesem Zusammenhang die mit- und gegenlaufenden Störfeldkomponenten einer bestimmten Polpaarzahl.

In der DE 36 00 814 C2 wird eine elektrische Meßeinrichtung zur Erfassung von Wicklungsfehlern im Ständer von Drehfeldmaschinen vorgeschlagen, mit der Veränderungen des Feldspektrums im Luftspalt der Maschine im gestörten Zustand gemessen und mit dem Feldspektrum im ungestörten Betrieb verglichen werden.

Die Meßeinrichtung erfordert die Einbringung von Meßspulen in die Nuten des Ständerblechpaketes.

Ähnliche Meßspulensysteme, die auf die bei elektrischen Unsymmetrien in Käfigläufern hinzutretenden Luftspaltfelder abgestimmt sind, werden in der DE 29 21 724 A1 beschrieben.

Weiterhin bekannt ist die berührungslose Abtastung mittels Magnetfeldsonde, um Lunker, Risse oder Unterbrechungen in den Kurzschlußringen und/oder Läuferstäben zu erfassen, so in den DE OS 28 27 203 und DE 30 45 195 A1 beschrieben.

Die Messung der aus dem Störfeld herrührenden magnetischen Störflüsse mit Prüfspulen erfordert zusätzlichen konstruktiven und fertigungstechnischen Aufwand und ist zudem für Störeinkopplungen stark anfällig.

Aus der EP 0 250 799 B1 ist ein Verfahren zur Überwachung des Zustandes einer Asynchronmaschine durch die Bestimmung von den Zustand der Asynchronmaschine charakterisierenden Parametern aus den bei laufender Asynchronmaschine ermittelten komplexen Eingangsimpedanzen bekannt. Mit diesem Verfahren ist insbesondere die Größe des Luftspaltes über die Überwachung der Hauptinduktivität bestimmbar und damit eine Aussage zu Lagerdefekten, Wellenverkrümmungen und dgl. möglich.

In der EP 0 675 369 A2 ist des weiteren ein Diagnosesystem für rotierende elektrische Maschinen beschrieben, welches die Meßsignalumwandlung in digitale Daten und deren Auswertung in einem Mikroprozessor vorsieht.

In der US-A-4 761 703 ist ein Verfahren zur Früherkennung von Läuferschäden vorgeschlagen. Bei diesem Verfahren wird neben dem Frequenzspektrum eines Motorstroms das Frequenzspektrum des axialen Flusses im Motor analysiert.

Nachteilig ist es bei allen bekannten Verfahren, daß sie nicht ausreichend zuverlässig mit einfachen Mitteln und unter den rauhen Bedingungen des Fahrbetriebes die Früherkennung von bereits geringen Läuferschäden gewährleisten.

Aufgabe der Erfindung ist es, ein Verfahren zur Früherkennung von Läuferschäden bei Asynchronmaschinen zu entwickeln, mit dem die Nachteile des Standes der Technik vermieden werden und mit dem mittels eines einfachen Aufbaus der Meßtechnik eine leicht zu handhabende, zuverlässige, bahntaugliche Ermittlung auch von kleinen Läuferschädigungen gewährleistet ist.

Die Lösung dieser Aufgabe ergibt sich aus den Merkmalen des Anspruchs 1. Die Ermittlung einer niederfrequenten Störkomponente im Motorstrom, welche die Bedingung $f_{stor} = (1-2s) f1$ erfüllt, gewährleistet die Früherkennung auch von kleinen Läuferschädigungen mit großer Zuverlässigkeit unter den Bedingungen des Bahnbetriebs. Die Bahntauglichkeit wird durch einen einfachen Aufbau der Meßkonfiguration erreicht, die einfach zu transportieren und zu handhaben ist. Es werden die auf dem Fahrzeug vorhandenen Meßsignale aus der Antriebssteuerung benutzt. Die Vergrößerung des Signal-Stör-Abstandes durch die Frequenzanalyse mittels FFT (Fast Fourier Transformation) mit hoher Frequenzauflösung, die nachabtastung, die nochmalige Frequenzanalyse, die Anwendung der symmetrischen Komponenten, die Auswertung des Drehzahlsignals gewährleisten die Bahntauglichkeit. Störeinkopplungen werden unterdrückt, durch eine Plausibilitätsüberprüfung werden nicht verwertbare Messuns ausgesondert. Unbedingte Voraussetzung zur Messung ist die Realisierung eines konstanten Betriebspunktes, d.h. die Einhaltung einer konstanten Geschwindigkeit bei konstant hoher Belastung.

Vorteilhafte Ausführungsformen der Erfindung sind in den Unteransprüchen beschrieben.

Die Erfindung wird nachfolgend anhand einer Zeichnung in einem Ausführungsbeispiel näher beschrieben. Es zeigen:

Fig. 1 :     eine Prinzipskizze des Meßaufbaus,

Fig. 2 :     das Spektrum des Motorstroms bei intaktem Läufer und

Fig. 3 :     das Spektrum des Motorstroms bei einem Schadläufer.

Das Störfeld bzw. alle Störfeldharmonischen induzieren Spannungen in der Ständerwicklung, die Störströme im Motorstrom zur Folge haben. Die Frequenzen dieser Störströme sind schlupfabhängig und berechnen sich nach der Beziehung

$$\text{fstör} = \gamma/p(1-s) \dotplus s | \ f_1,$$

wobei bedeuten:

$\gamma$ : Ordnungszahlen der Störfeldharmonischen,
s : Grundwellenschlupf,
$f_1$ : Ständerfrequenz.

Die vor allem interessierenden Frequenzen ergeben sich danach für die mit- und gegenlaufenden Störfelder mit der Polpaarzahl der Grundwelle des ungestörten Luftspaltfeldes

$$\gamma/p = 1 \quad \text{(mitlaufend)} \quad \text{mit } f_{stor} = f_1$$

$$\gamma/p = -1 \quad \text{(mitlaufend)} \quad \text{mit } f_{stor} = (1-2s) \ f_1.$$

Das Meßverfahren bezieht sich auf die Ermittlung der Komponente im Spektrum des Motorstroms mit der Frequenz $f_{stor} = (1-2s) \ f_1$, die dieselbe Phasenfolge hat wie die Grundschwingung.

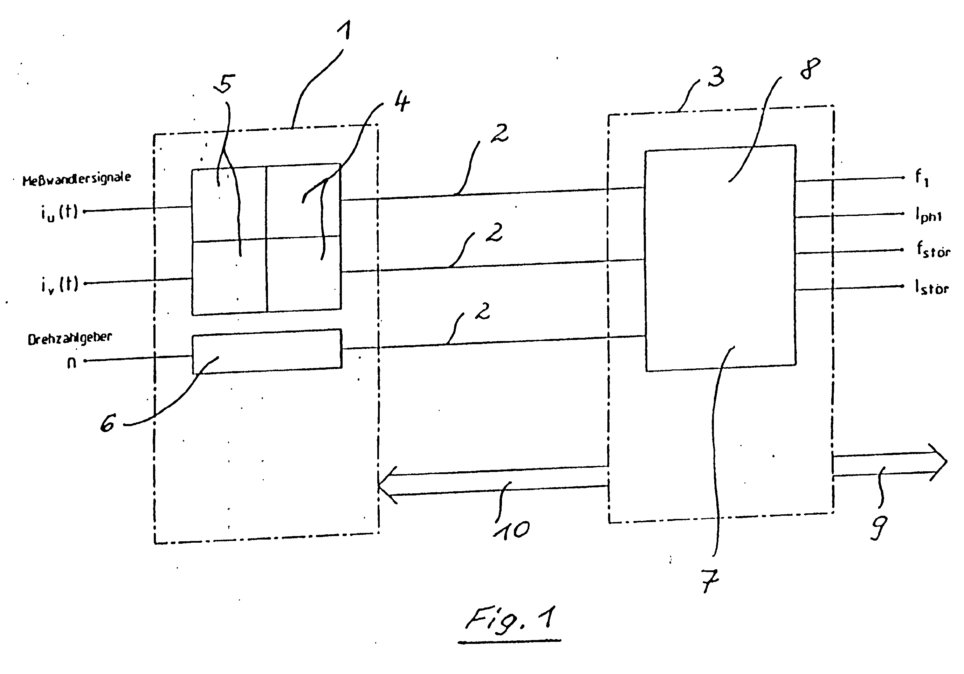

Entsprechend der Darstellung in der Fig. 1 besteht der Meßaufbau im wesentlichen aus einem Meßaufnahmesystem 1 zur Messung zweier Motorstrommeßsignale $i_u(t)$, $i_v(t)$ und eines Drehzahlsignals n aus der Antriebssteuerung, aus Leitungen 2 zur Meßdatenübertragung über eine geeignete Schnittstelle auf einen Computer 3, in dem eine Meßdatenauswertung bzw. Meßdatenverarbeitung und eine Protokollierung 9 erfolgen.

Der Meßablauf kann automatisiert und über eine grafische Bedienoberfläche in einfacher Weise gesteuert werden.

Als Motorstrommeßsignale $i_u(t)$, $i_v(t)$ dienen die entsprechenden Meßwandlersignale, die auch in der Antriebssteuerung verwendet werden. Die Meßwandlersignale werden im Meßaufnahmesystem 1 in einer Filter- und Abtasteinrichtung 5 mit einem Tiefpaß gefiltert und mit einer geeigneten Abtastrate abgetastet. Die aufgenommenen Zeitsignale werden in einem A/D-Wandler 4 16bit-A/D-gewandelt auf den Personalcomputer 3, zum Beispiel ein Notebook, übertragen und dort ausgewertet.

Als Drehzahlsignale n dienen die Impulse aus dem Inkrementalgeber des Motors, die ebenfalls in der Antriebssteuerung Verwendung finden. Sie werden in dem Inkrementalgeberinterface (Signalaufbereitung 6) des Meßaufnahmesystems 1 ausgewertet und als zeitlicher Drehzahlverlauf über die Meßdatenübertragung 2 auf den Computer 3 übertragen.

Der Drehzahlverlauf dient zur Bestimmung der mittleren Drehzahl während der Messung und darüber hinaus zum Erkennen von nichtkonstanten Betriebspunkten, zum Beispiel infolge von durchdrehenden Rädern auf nasser Schiene oder von Beschleunigungsvorgängen.

Um bei der Meßdatenauswertung im Computer 3 durch einen FFT-Analysator 8 und durch die Bestimmung der symmetrischen Komponenten 7 eine hinreichende spektrale Auflösung von zum Beispiel 0,2 Hz zu erreichen, muß die eigentliche Meßzeit fünf Sekunden betragen. Aus dem ermittelten Spektrum und der mittleren Drehzahl lassen sich dann die vier interessierenden Größen Ständerfrequenz $f_1$, Grundschwingungseffektivwert $I_{ph1}$, Frequenz der Störkomponente $f_{stor}$ und Effektivwert der Störkomponente $I_{stor}$ bestimmen.

Die Meßablaufsteuerung 10 dient der Plausibilitätsüberprüfung der gemessenen Daten, mit welcher nichtrelevante Daten ausgesondert werden können.

Die beschriebene Meßtechnik ist in kurzer Zeit auf einem Fahrzeug, zum Beispiel einer Lokomotive, zu installieren und leicht zu handhaben. Der notwendige, hinreichend konstante Betriebspunkt, d.h. eine konstante Geschwindigkeit bei konstant hoher Belastung, ist im automatischen Betrieb einer Lokomotive gut zu realisieren, zum Beispiel bei einer Fahrzeuggeschwindigkeit von 90 km/h unter voller Belastung. Die automatische Plausibilitätsüberprüfung macht nicht verwertbare Messungen, zum Beispiel bei zu geringer Belastung, kein konstanter Betriebspunkt, unrealistische Betriebsdaten, kenntlich.

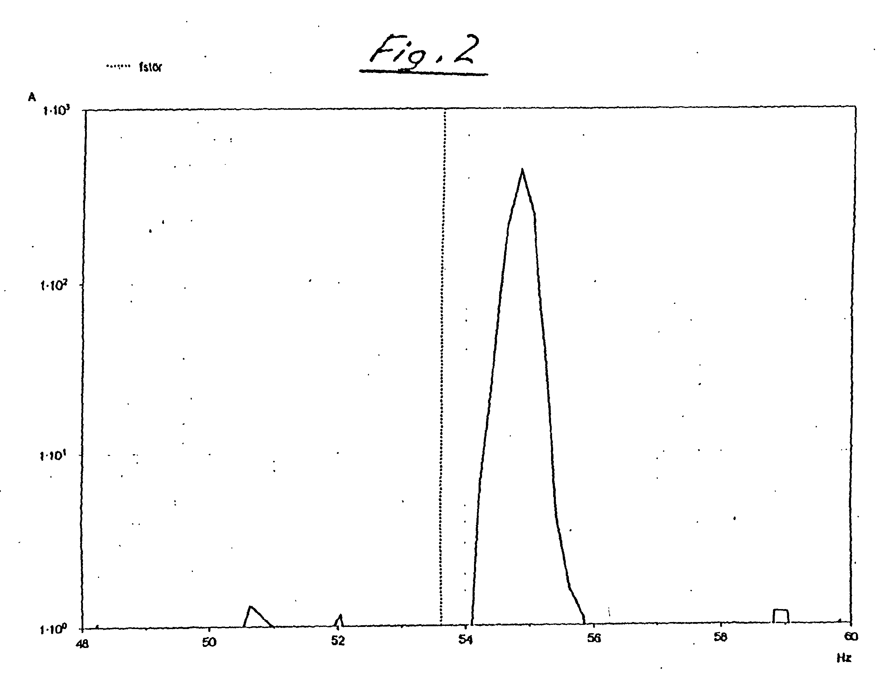

Die Fig. 2 zeigt ein auf dem Fahrzeug ermitteltes Motorstromspektrum, welches bezüglich der Störkomponente fstör nicht auffällig ist, also nicht auf eine Läuferschädigung schließen läßt.

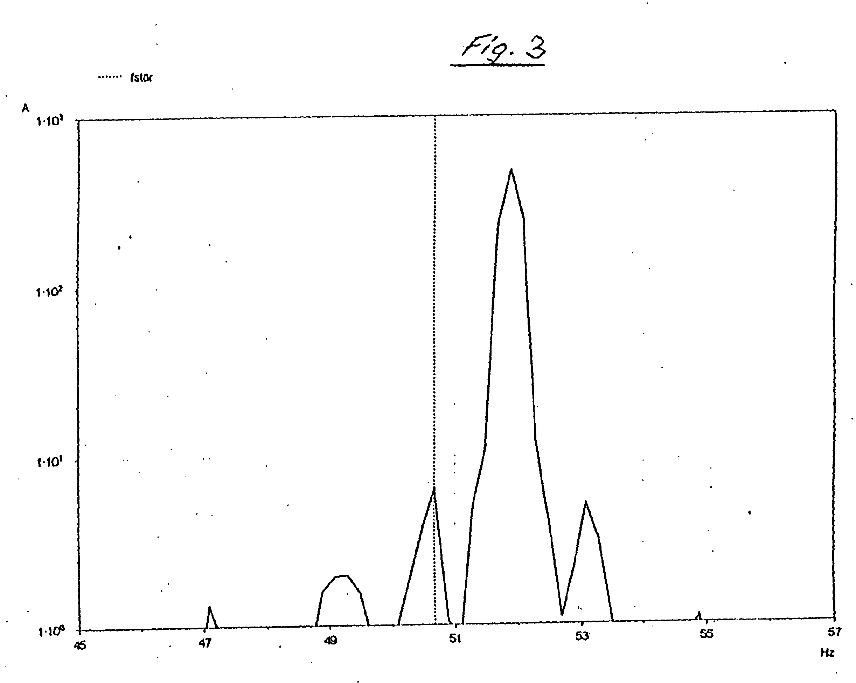

In der Fig. 3 ist ein auf dem Fahrzeug ermitteltes Motorstromspektrum, das eine sehr ausgeprägte Störkomponente $f_{stör}$ zeigt, dargestellt, die von einer Reihe von Stabbrüchen herrühren.

Bezugszeichenliste

| | |
|---|---|
| 1 | Meßaufnahmesystem |
| 2 | Meßdatenübertragung |
| 3 | Personalcomputer (Meßdatenverarbeitung) |
| 4 | A/D-Wandler |
| 5 | Tiefpaßfilter- und Abtasteinrichtung |
| 6 | Signalaufbereitung |
| 7 | Einrichtung zur Bestimmung von symmetrischen Komponenten |
| 8 | FFT (Fast Fourier Transformation) |
| 9 | Protokollierung |
| 10 | Meßablaufsteuerung |
| $i_u(t)$ | Meßwandlersignal |
| $i_v(t)$ | Meßwandlersignal |
| n | Drehzahlgebersignal |
| $f_1$ | Ständerfrequenz |
| $I_{ph1}$ | Grundschwingungseffektivwert |
| $f_{stör}$ | Frequenz der Störkomponente |
| $I_{stör}$ | Effektivwert der Störkomponente |
| S | Grundwellenschlupf |

**Patentansprüche**

1. Verfahren zur Früherkennung von Läuferschäden bei Asynchronmaschinen unter Heranziehung des Motorstromes als Messsignal und Verwendung der Spektralanalyse des Motorstroms für die Ermittlung spektraler Störkomponenten als Kenngröße der Läuferschädigung, wobei die Meßsignale in digitale Daten umgewandelt und in einem Rechner, beispielsweise einem Personalcomputer, ausgewertet werden,
   **dadurch gekennzeichnet, daß**

   - als Meßsignale zwei Motorströme $i_v(t)$, $i_u(t)$ der Ständerwicklung herangezogen werden,
   - zusätzlich die Motordrehzahl n gemessen wird,
   - aus den Frequenzspektren der Motorströme $i_v(t)$, $i_u(t)$ die Frequenzkomponenten mit derselben Phasenfolge wie die Grundschwingung ermittelt werden,
   - in diesem Frequenzspektrum des jeweiligen Motorstroms $i_v(t)$, $i_u(t)$ die Frequenz $f_1$ der Grundschwingung und mit der ermittelten Drehzahl der Grundwellenschlupf s ermittelt werden und damit die Frequenz $f_{stör}$ einer spektralen Störkomponente mit der Polpaarzahl p der Grundwelle des ungestörten Luftspaltfeldes und der Ordnungszahl λ der Störfeldharmonischen zu

$$f_{st\ddot{o}r} = \left| \frac{\lambda}{p}(1-s) + s \right| f_1$$

ermittelt wird,
- im Frequenzspektrum des jeweiligen Motorstroms $i_v(t)$, $i_u(t)$ der Effektivwert $I_{ph1}$ der spektralen Komponente bei der Grundfrequenz $f_1$, und der Effektivwert $I_{st\ddot{o}r}$ der spektralen Störkomponente bei der Störfrequenz $f_{st\ddot{o}r}$ ermittelt werden, und
- der ermittelte Effektivwert $I_{st\ddot{o}r}$ des jeweiligen Motorstroms $i_v(t)$, $i_u(t)$ unter der Voraussetzung konstanter Drehzahl n während der für die Spektralanalyse des jeweiligen Motorstroms $i_v(t)$, $i_u(t)$ notwendigen Meßzeit als Kenngröße für die Läuferschädigung protokolliert wird.

2. Verfahren nach Anspruch 1,
**dadurch gekennzeichnet, daß**
im jeweiligen Frequenzspektrum der Motorstrommeßsignale $i_v(t)$, $i_u(t)$ die spektrale Störkomponente mit einer Frequenz $f_{st\ddot{o}r}$ ermittelt wird, welche dieselbe Phasenfolge wie die Grundschwingung hat und die Frequenz $f_{st\ddot{o}r} = (1-2s)$ $f_1$ aufweist, wobei $f_1$ die Grundfrequenz und s den Grundwellenschlupf darstellen.

3. Verfahren nach einem der Ansprüche 1 bis 2,
**dadurch gekennzeichnet, daß**
zur Messung der Motordrehzahl n die Impulse aus einem Inkrementalgeber des Motors herangezogen werden, welche mittels eines Meßaufnahmesystems (1) aufgenommen und über eine Meßdatenübertragung (2) und über eine Schnittstelle dem Rechner (3) zugeführt werden.

4. Verfahren nach Anspruch 3,
**dadurch gekennzeichnet, daß**
die jeweiligen Motorstrommeßsignale $i_v(t)$, $i_u(t)$ in einer Filter- und Abtasteinrichtung (5) tiefpaßgefiltert, abgetastet und anschließend digitalisiert an den Rechner (3) übertragen werden.

5. Verfahren nach Anspruch 3,
**dadurch gekennzeichnet, daß**
die Impulse zur Messung der Motordrehzahl n in einem Inkrementalgeberinterface des Meßaufnahmesystems (1) ausgewertet und als zeitlicher Verlauf der Motordrehzahl n an den Rechner (3) übertragen werden.

6. Verfahren nach einem der Ansprüche 1 bis 3,
**dadurch gekennzeichnet, daß**
die Meßzeit mindestens 5 Sekunden beträgt.

7. Verfahren nach einem der Ansprüche 1 bis 6,
**dadurch gekennzeichnet, daß**
im jeweiligen Frequenzspektrum der Motorstrommesssignale $i_v(t)$, $i_u(t)$ die symmetrischen Komponenten bestimmt werden

8. Anordnung zur Durchführung des Verfahrens nach einem der Ansprüche 1 bis 7,
**dadurch gekennzeichnet, daß**
ein Meßaufnahmesystem (1) vorgesehen ist, mit Eingängen für die Motorstrommeßsignale $i_v(t)$, $i_u(t)$ und dem Motordrehzahlsignal n, und mit Ausgängen, welche über Leitungen zur Meßdatenübertragung (2) mit einem Rechner (3) zur Meßdatenverarbeitung, beispielsweise einem Personalcomputer verbunden sind, wobei der Rechner (3) Ausgänge für die Ausgabe der Größen der jeweiligen Grundfrequenz $f_1$, des jeweiligen Effektivwerts $I_{phi}$ der spektralen Komponente bei der Grundfrequenz $f_1$, der jeweiligen Frequenz $f_{st\ddot{o}r}$ der Störkomponente, des jeweiligen Effektivwerts $I_{st\ddot{o}r}$ der spektralen Störkomponente sowie für die Protokollierung aufweist, und zur Plausibilitätsüberprüfung eine Rückkopplung (10) vom Rechner (3) zum Meßaufnahmesystem (1) vorgesehen ist, wobei der Rechner

- aus den Frequenzspektren der Motorströme $i_v(t)$, $i_u(t)$ die Frequenzkomponenten mit derselben Phasenfolge wie die Grundschwingung ermittelt,
- in diesem Frequenzspektrum des jeweiligen Motorstroms $i_v(t)$, $i_u(t)$ die Frequenz $f_1$ der Grundschwingung und

mit der ermittelten Drehzahl der Grundwellenschlupf s ermittelt und damit die Frequenz $f_{stör}$ einer spektralen Störkomponente mit der Polpaarzahl p der Grundwelle des ungestörten Luftspaltfeldes und der Ordnungszahl λ der Störfeldharmonischen zu

$$ f_{stör} = \left| \frac{\lambda}{p}(1-s)+s \right| f_1 $$

ermittelt,
- im jeweiligen Frequenzspektrum des jeweiligen Motorstroms $i_v(t)$, $i_u(t)$ der Effektivwert $I_{ph1}$ der spektralen Komponente bei der Grundfrequenz $f_1$, und der Effektivwert $I_{stör}$ der spektralen Störkomponente bei der Störfrequenz $f_{stör}$ ermittelt, und
- den ermittelten Effektivwert $I_{stör}$ unter der Voraussetzung konstanter Drehzahl n während der für die Spektralanalyse des jeweiligen Motorstroms $i_v(t)$, $i_u(t)$ notwendigen Meßzeit als Kenngröße für die Läuferschädigung protokolliert.

9. Anordnung nach Anspruch 8,
   **dadurch gekennzeichnet, daß**
   im Meßaufnahmesystem (1) für jedes Motorstrommesssignal $i_v(t)$, $i_u(t)$ eine Filter- und Abtasteinrichtung (5) und ein A/D-Wandler (4) und für das Motordrehzahlsignal n eine Signalaufbereitung (6) vorgesehen sind.

10. Anordnung nach Anspruch 8,
    **dadurch gekennzeichnet, daß**
    im Rechner (3) die Spektralananyse der Meßstromsignale $i_v(t)$, $i_u(t)$ sowie die Bestimmung der symmetrischen Komponenten durchführbar ist.

**Claims**

1. Method for early recognition of rotor damage in asynchronous machines, making use of the motor current as a measurement signal and using spectral analysis of the motor current to detect spectral disturbance components as characteristic value of rotor damage, wherein the measurement signals are converted into digital data and evaluated in a computer, for example a personal computer,
   **characterised in that**

   - as measurement signals recourse is made to two motor currents $i_v(t)$, $i_u(t)$ of the stator winding,
   - additionally, the motor revolution speed n is measured,
   - from the frequency spectra of the motor currents $i_v(t)$, $i_u(t)$, the frequency components with the same phase sequence as the fundamental oscillation are determined,
   - in this frequency spectrum of the respective motor current $i_v(t)$, $i_u(t)$, the frequency $f_1$ of the fundamental oscillation and with the revolution speed determined the fundamental wave slip s are determined and thereby the frequency $f_{stör}$ of a spectral disturbance component with the pole pair number p of the fundamental wave of the undisturbed air-gap field and the ordinal number λ of the disturbance field harmonic is determined according to

$$ f_{stör} = \left| \frac{\lambda}{\rho}(1-s)+s \right| \; f_1 $$

   - in the frequency spectrum of the respective motor current $i_v(t)$, $i_u(t)$, the effective value $I_{ph1}$ of the spectral component at the fundamental frequency $f_1$ and the effective value $I_{stör}$ of the spectral disturbance component at the disturbance frequency $f_{stör}$ are determined and,
   - under the precondition of constant revolution speed n during the measurement time necessary for the spectral analysis of the respective motor current $i_v(t)$, $i_u(t)$, the effective value $I_{stör}$ determined of the respective motor current $i_v(t)$, $i_u(t)$ is recorded as a characteristic value for the rotor damage.

**2.** Method according to Claim 1, **characterised in that,**
in the respective frequency spectrum of the motor current measurement signals $i_v(t)$, $i_u(t)$, the spectral disturbance component with a frequency $f_{stör}$ is determined, which has the same phase sequence as the fundamental oscillation and has the frequency $f_{stör} = (1-2s) f_1$, wherein $f_1$ represents the fundamental frequency and s represents the fundamental wave slip.

**3.** Method according to one of Claims 1 and 2,
**characterised in that** to measure the motor revolution speed n, the pulses from an incremental transmitter of the motor are taken, which are recorded by means of a measurement recording system (1) and transferred via a measurement data transfer system (2) and via an interface to the computer (3).

**4.** Method according to Claim 3, **characterised in that**
the respective motor current measurement signals $i_v(t)$, $i_u(t)$ are low-pass filtered and scanned in a filter and scanning device (5) and then transferred in digitised form to the computer (3).

**5.** Method according to Claim 3, **characterised in that**
the pulses for measuring the motor revolution speed n are evaluated in an incremental transmitter interface of the measurement recording system (1) and transferred as a temporal progression of the motor revolution speed n to the computer (3).

**6.** Method according to one of Claims 1 to 3, **characterised in that** the measurement time is at least 5 seconds.

**7.** Method according to one of Claims 1 to 6, **characterised in that** in the respective frequency spectrum of the motor current measurement signals $i_v(t)$, $i_u(t)$ the symmetrical components are determined.

**8.** Arrangement for carrying out the method according to any one of Claims 1 to 7, **characterised in that** a measurement recording system (1) is provided, with inputs for the motor current measurement signals $i_v(t)$, $i_u(t)$ and for the motor revolution speed signal n, and with outputs which are connected by lines to the measurement data transfer device (2) with a computer (3) for measurement data processing, such as a personal computer, wherein the computer (3) has outputs for outputting the values of the respective fundamental frequency $f_1$, the individual effective value $I_{phi}$ of the spectral component at the fundamental frequency $f_1$, the individual frequency $f_{stör}$ of the disturbance component, the individual effective value $I_{stör}$ of the spectral disturbance component, as well as for recording, and for the validation check a feedback (10) from the computer (3) to the measurement recording system (1) is provided, wherein the computer

    - determines from the frequency spectra of the motor currents $i_v(t)$, $i_u(t)$ the frequency components with the same phase sequence as the fundamental oscillation,
    - determines in this frequency spectrum of the respective motor current $i_v(t)$, $i_u(t)$ the frequency $f_1$ of the fundamental oscillation and with the revolution speed determined the fundamental wave slip s and thereby determines the frequency $f_{stör}$ of a spectral disturbance component with the pole pair number p of the fundamental wave of the undisturbed air-gap field and the ordinal number $\lambda$ of the disturbance field harmonic according to

$$f_{stör} = \left| \frac{\lambda}{\rho}(1-s) + s \right| \; f_1$$

    - determines in the respective frequency spectrum of the respective motor current $i_v(t)$, $i_u(t)$, the effective value $I_{ph1}$ of the spectral component at the fundamental frequency $f_1$ and the effective value $I_{stör}$ of the spectral disturbance component at the disturbance frequency $f_{stör}$ and,
    - under the precondition of constant revolution speed n during the measurement time necessary for the spectral analysis of the respective motor current $i_v(t)$, $i_u(t)$, records the effective value $I_{stör}$ determined as a characteristic value for the rotor damage.

**9.** Arrangement according to Claim 8, **characterised in that** in the measurement recording system (1) a filter and scanning device (5) and an A/D converter (4) are provided for each motor current measurement signal $i_v(t)$, $i_u(t)$ and a signal processing arrangement (6) is provided for the motor revolution speed signal n.

**10.** Arrangement according to Claim 8, **characterised in that** in the computer (3) the spectral analysis of the measurement current signals $i_v(t)$, $i_u(t)$ can be carried out as well as the determination of the symmetrical components.

**Revendications**

**1.** Procédé de détection précoce de dommages au niveau du rotor pour les machines asynchrones se servant du courant de moteur comme signal de mesure et en utilisant l'analyse spectrale du courant de moteur pour déterminer les composantes parasites spectrales comme caractéristique de l'endommagement du rotor, les signaux de mesure étant convertis en données numériques et exploités dans un ordinateur, par exemple un ordinateur personnel, **caractérisé en ce que**

- deux courants de moteur $i_v(t)$, $i_u(t)$ de l'enroulement du stator sont pris comme signaux de mesure,
- la vitesse de moteur n est également mesuré,
- les composantes de fréquence de même ordre de phase que l'oscillation fondamentale, sont déterminés à partir des spectres de fréquences des courants de moteur $i_v(t)$, $i_u(t)$,
- dans ce spectre de fréquences du courant de moteur $i_v(t)$, $i_u(t)$ respectif, la fréquence $f_1$ de l'oscillation fondamentale et avec la vitesse de moteur déterminé, le glissement de l'oscillation fondamentale s, sont déterminés, et la fréquence $f_{stör}$ d'une composante parasite spectrale avec la polarité p de l'oscillation fondamentale du champ d'entrefer non perturbé et le rang $\lambda$ des harmoniques du champ parasite est déterminée par

$$f_{stör} = \left| \frac{\lambda}{\rho}(1 - s) + s \right| f_1$$

- dans le spectre de fréquences du courant de moteur $i_v(t)$, $i_u(t)$ respectif, la valeur efficace $I_{ph1}$ de la composante spectrale à la fréquence fondamentale $f_1$ et la valeur efficace $I_{stör}$ de la composante parasite spectrale à la fréquence parasite $f_{stör}$ sont déterminées et
- la valeur efficace $I_{stör}$ déterminée du courant de moteur $i_v(t)$, $i_u(t)$ respectif est enregistrée en tant que caractéristique pour l'endommagement du rotor à condition que la vitesse de moteur n soit constant pendant la période de mesure nécessaire à l'analyse spectrale du courant de moteur $i_v(t)$, $i_u(t)$ respectif.

**2.** Procédé selon la revendication 1, **caractérisé en ce que** dans chaque spectre de fréquences des signaux de courants de moteur $i_v(t)$, $i_u(t)$, la composante parasite spectrale est déterminée avec une fréquence $f_{stör}$, laquelle présente le même ordre de phase que l'oscillation fondamentale, ainsi que la fréquence $f_{stör} = (1-2s)f_1$ où $f_1$ représente la fréquence fondamentale et s le glissement de l'oscillation fondamentale.

**3.** Procédé selon l'une des revendications 1 à 2, **caractérisé en ce que** les impulsions issues d'un codeur incrémental du moteur sont utilisées pour mesurer la vitesse de moteur n, lesquelles sont enregistrées au moyen d'un système d'enregistrement de mesure (1) et transmises à l'ordinateur (3) via un transfert de données de mesure (2) et une interface.

**4.** Procédé selon la revendication 3, **caractérisé en ce que** les signaux de courants de moteur $i_v(t)$, $i_u(t)$ respectifs sont traités au filtre passe-bas et balayés dans un dispositif de filtrage et de balayage (5) et enfin numérisés pour être transmis à l'ordinateur (3).

**5.** Procédé selon la revendication 3, **caractérisé en ce que** les impulsions sont exploitées dans une interface de codeur incrémental du système d'enregistrement de mesure (1) afin de mesurer la vitesse de moteur n et sont transmises à l'ordinateur (3) en tant que variation temporelle de la vitesse de moteur n.

**6.** Procédé selon l'une des revendications 1 à 3, **caractérisé en ce que** le temps de mesure est d'au moins 5 secondes.

**7.** Procédé selon l'une des revendications 1 à 6, **caractérisé en ce que** dans chaque spectre de fréquences des signaux de courants de moteur $i_v(t)$, $i_u(t)$, les composantes symétriques sont déterminées.

**8.** Disposition pour exécuter le procédé selon l'une des revendications 1 à 7, **caractérisée en ce qu'**un système d'enregistrement de mesure (1) est prévu avec des entrées pour les signaux de courants de moteur $i_v(t)$, $i_u(t)$ et le signal de vitesse de moteur n, ainsi qu'avec des sorties, lesquelles sont reliées à un ordinateur (3), par exemple un ordinateur personnel, via des connexions prévues pour le transfert des données de mesure (2) en vue du traitement des données de mesure, l'ordinateur (3) présentant des sorties pour l'émission des grandeurs de chaque fréquence fondamentale $f_1$, de chaque valeur efficace $I_{phi}$ de la composante spectrale à la fréquence fondamentale $f_1$, de chaque fréquence $f_{stör}$ de la composante parasite, de chaque valeur efficace $I_{stör}$ de la composante parasite spectrale, ainsi que pour la journalisation, et un rétro-couplage (10) de l'ordinateur (3) au système d'enregistrement de mesure (1) est prévu pour le contrôle de plausibilité, l'ordinateur

- déterminant, à partir des spectres de fréquences des courants de moteur $i_v(t)$, $i_u(t)$, les composantes de fréquence de même ordre de phase, telles que l'oscillation fondamentale,
- déterminant, dans ce spectre de fréquences du courant de moteur $i_v(t)$, $i_u(t)$ respectif, la fréquence $f_1$ de l'oscillation fondamentale et avec la vitesse de moteur déterminé, le glissement de l'oscillation fondamentale, et déterminant la fréquence $f_{stör}$ d'une composante parasite spectrale avec la polarité p de l'oscillation fondamentale du champ d'entrefer non perturbé et le rang $\lambda$ des harmoniques du champ brouilleur par

$$ f_{stör} = \left| \frac{\lambda}{\rho}(1-s) + s \right| f_1 $$

- déterminant, dans le spectre de fréquences respectif du courant de moteur $i_v(t)$, $i_u(t)$ respectif, la valeur efficace $I_{ph1}$ de la composante spectrale à la fréquence fondamentale $f_1$ et la valeur efficace $I_{stör}$ de la composante parasite spectrale à la fréquence parasite $f_{stör}$ et
- enregistrant la valeur efficace $I_{stör}$ déterminée en tant que caractéristique pour l'endommagement du rotor à condition que la vitesse de moteur n soit constant pendant la période de mesure nécessaire à l'analyse spectrale du courant de moteur $i_v(t)$, $i_u(t)$ respectif.

9. Disposition selon la revendication 8, **caractérisée en ce que** dans le système d'enregistrement de mesure (1), un dispositif de filtrage et de balayage (5) et un encodeur analogique-numérique (4) sont prévus pour chaque signal des courants de moteur $i_v(t)$, $i_u(t)$ et un traitement des signaux (6) est prévu pour le signal de vitesse de moteur n.

10. Disposition selon la revendication 8, **caractérisée en ce que** l'analyse spectrale des signaux de courants de mesure $i_v(t)$, $i_u(t)$, ainsi que la détermination des composantes symétriques peuvent être exécutées dans l'ordinateur (3).

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3600814 C2
- DE 2921724 A1
- DE 2827203 A
- DE 3045195 A1
- EP 0250799 B1
- EP 0675369 A2
- US 4761703 A

**In der Beschreibung aufgeführte Nicht-Patentliteratur**

- **DELEROI, W.** Der Stabbruch im Käfigläufer eines Asynchronmotors. *Archiv für Elektrotechnik,* 1984, vol. 67
- **KREBS, R.** Läuferanisotropien bei Asynchronmaschinen mit Kurzschlußläufer. *Archiv für Elektrotechnik,* 1988, vol. 71